# EUROPÄISCHE PATENTSCHRIFT

(11) **EP 2 778 119 B1**
(45) Veröffentlichungstag und Bekanntmachung des Hinweises auf die Patenterteilung: **18.05.2016**
(21) Anmeldenummer: 14157456.6
(22) Anmeldetag: 03.03.2014
(51) Int. Cl.: B81B 7/00

(54) **Sensor und Verfahren zum Herstellen einer flexiblen Lötverbindung zwischen einem Sensor und einer Leiterplatte**
Sensor and method for the production of a flexible soldered joint between a sensor and a printed circuit board
Capteur et procédé de fabrication d'une liaison brasée flexible entre un capteur et un circuit imprimé

(30) Priorität: 12.03.2013 DE 102013204234
(43) Veröffentlichungstag der Anmeldung: 17.09.2014
(73) Patentinhaber: ROBERT BOSCH GMBH, 70442 Stuttgart (DE)
(72) Erfinder: Ehrenpfordt, Ricardo, 70825 Korntal-Muenchingen (DE); Pantel, Daniel, 71254 Ditzingen (DE); Ante, Frederik, 70197 Stuttgart (DE)

(56) Entgegenhaltungen:
- WO-A1-2009/060029
- DE-A1-102004 031 888
- US-A1- 2003 121 698
- US-A1- 2007 206 367

## Beschreibung

### Stand der Technik

Die vorliegende Erfindung bezieht sich auf einen Sensor sowie auf ein Verfahren zum Herstellen einer Lötverbindung zwischen einem Sensor und einer Leiterplatte.

Ein mikroelektromechanisches Sensorelement (MEMS) kann eine Bewegung zumindest eines Bestandteils des Sensorelements in ein elektrisches Signal abbilden. Bestimmungsgemäß wird die Bewegung durch eine physikalische Größe verursacht, die an dem Sensorelement anliegt.

Die DE 10 2011 004 577 A1 beschreibt einen Bauelementträger und ein Bauteil mit einem MEMS-Bauelement auf einem solchen Bauelementträger.

Die WO 2009/060029 A1 betrifft eine elektronische Komponente mit mechanisch entkoppelten bällartigen Verbindungen. Die Entkopplung wird durch eine Kavität erreicht, die in einer Trägerstruktur zum Tragen der elektronischen Komponente angeordnet ist. Die US 2007/206367 A1 betrifft ein elektronisches Gerät mit einem Gehäuse, das Rillen aufweist, durch das Gehäuse in Befestigungsabschnitte und einen Funktionsabschnitt unterteilt wird. Die US 2003/121698 A1 betrifft ein Halbleiterbauteil mit einer Elektrodenfläche, wobei auf einer ersten Seite der Elektrodenfläche ein Lötball und auf einer zweiten Seite der Elektrodenfläche eine Kavität in einer Vergussmasse ausgebildet ist. Die DE 10 2004 031888 A1 betrifft ein Halbleiterbauteil mit Außenkontakten in Form von Lotkugeln, die auf einem freitragenden Membranfolienbereich fixiert sind.

### Offenbarung der Erfindung

Vor diesem Hintergrund wird mit der vorliegenden Erfindung ein Sensor sowie ein Verfahren zum Herstellen einer Lötverbindung zwischen einem Sensor und einer Leiterplatte gemäß den Hauptansprüchen vorgestellt. Vorteilhafte Ausgestaltungen ergeben sich aus den jeweiligen Unteransprüchen und der nachfolgenden Beschreibung.

Wenn eine Störgröße, beispielsweise eine thermomechanische Spannung oder eine Biegung, zusätzlich zu einer zu erfassenden physikalischen Größe auf ein Sensorelement einwirkt, kann das Sensorelement in einem von dem Sensorelement bereitgestellten elektrischen Signal verfälschte Werte für die physikalische Größe abbilden. Um das Sensorelement von der Störgröße zu entkoppeln, können elektrische Kontaktflächen und alternativ oder ergänzend mechanische Kontaktflächen einer Trägerstruktur des Sensorelements mechanisch von dem Sensorelement entkoppelt werden. Dazu kann die Trägerstruktur zumindest einen biegsamen Bereich aufweisen, durch den die Störgröße kompensiert oder reduziert werden kann. Durch das Entkoppeln kann das Sensorelement auch unter dem Einfluss einer Störgröße die zu erfassende physikalische Größe sicher erfassen und unverfälscht in dem elektrischen Signal abbilden.

Ein Sensor weist eine Trägerstruktur mit einem integrierten elektronischen Sensorelement auf, wobei die Trägerstruktur eine Kavität zum Ausbilden eines flexiblen Teilbereichs der Trägerstruktur aufweist, wobei der flexible Teilbereich zumindest eine Kontaktfläche zum Herstellen einer Lötverbindung aufweist, und ausgebildet ist, um die Kontaktfläche zumindest in einer Raumrichtung mechanisch zumindest teilweise von dem Sensorelement zu entkoppeln.

Ein Sensor kann ein Bauelement zum Erfassen zumindest einer physikalischen Größe sein. Eine Trägerstruktur kann eine Leiterplatte umfassen. Die Trägerstruktur kann ein Gehäuse des Sensors bilden. Ein Sensorelement kann ein Halbleiterbauteil sein. Die Kontaktfläche kann elektrisch mit dem Sensorelement verbunden sein. Beispielsweise kann das Sensorelement über Bonddrähte mit Leiterbahnen der Trägerstruktur verbunden sein. Eine Kavität kann eine Aussparung aus einem die Trägerstruktur bildenden Material sein. Beispielsweise kann die Kavität ein Hohlraum oder ein Schlitz sein. Die Kavität kann einen rechteckigen Grundriss aufweisen. Der Teilbereich der Trägerstruktur kann elastisch sein. Der Teilbereich kann als Biegefeder ausgebildet sein. Die zumindest eine Raumrichtung kann quer zu einer Haupterstreckungsebene der Trägerstruktur ausgerichtet sein. Durch die mechanische Entkopplung kann eine direkte Weiterleitung einer in der zumindest einen Raumrichtung auf die Kontaktfläche wirkenden Kraft auf das Sensorelement verhindert werden. Die Kontaktfläche kann eine Fläche zum mechanischen und alternativ oder ergänzend zum elektrischen Verbinden des Sensors mit einer Platine sein. Die Kontaktfläche kann eine metallische oder metallisierte Fläche sein, die dazu ausgebildet ist, von einem Lot benetzt zu werden. Die Kontaktfläche kann auf einer Lötseite des Sensors angeordnet sein. Die Kontaktfläche kann insbesondere quer zu der zumindest einen Raumrichtung ausgerichtet sein. Auf der Kontaktfläche kann eine Lotperle aus Lot angeordnet sein.

In der Kavität kann ein entfernbares Opfermaterial angeordnet sein. Das Opfermaterial kann dazu ausgebildet sein, den flexiblen Teilbereich während des Herstellens der Lötverbindung und alternativ oder ergänzend während des Herstellens des Sensors in der Raumrichtung zu fixieren. Ein Opfermaterial kann ein Hilfsmaterial bei der Herstellung des Sensors sein. Das Opfermaterial kann eine Platzhalterfunktion bei der Herstellung einnehmen. Das Opfermaterial kann beispielsweise gut durch ein Lösungsmittel lösbar sein. Ebenso kann ein Schmelzpunkt des Opfermaterials niedriger sein, als eine maximale erlaubte Temperatur des Sensors. Das Opfermaterial kann als Transportsicherung dienen.

In der Kavität kann ein Dämpfermaterial angeordnet sein, das dazu ausgebildet ist, Schwingungen des flexiblen Teilbereichs in der zumindest einen Raumrichtung zu tilgen. Ein Dämpfermaterial kann ein Gel sein. Das Dämpfermaterial kann Schwingungsenergie aufnehmen und beispielsweise in Wärme umwandeln oder durch eine plastische Verformung abbauen.

Der flexible Teilbereich kann ausgebildet sein, um die Kontaktfläche zumindest in einer weiteren Raumrichtung mechanisch mit dem Sensorelement zu koppeln. Die weitere Raumrichtung kann quer zu der Raumrichtung ausgerichtet sein, in der der flexible Teilbereich von dem Sensorelement entkoppelt ist. Die Raumrichtungen können orthogonal zueinander ausgerichtet sein. Beispielsweise kann das Sensorelement in einer Z-Richtung entkoppelt sein und in einer X-Richtung und alternativ oder ergänzend in einer Y-Richtung mit dem Sensorelement gekoppelt sein. Durch die Kopplung kann das Sensorelement Bewegungen in der gekoppelten Raumrichtung erfassen.

Die Trägerstruktur kann eine erste Lage und zumindest eine zweite Lage umfassen. Dabei kann die Kavität zwischen der ersten Lage und der zweiten Lage angeordnet sein. Die Kontaktfläche kann an der ersten Lage, gegenüberliegend zu der Kavität angeordnet sein. Die erste Lage kann zumindest teilweise als der flexible Teilbereich ausgebildet sein. Das Sensorelement kann an oder in der zweiten Lage angeordnet sein. Die erste Lage und die zweite Lage können außerhalb eines Bereichs um die Kontaktstelle miteinander verbunden sein. Durch einen schichtweisen Aufbau kann die Kavität einfach und schnell erstellt werden. Beispielsweise kann zwischen der ersten und der zweiten Lage eine Zwischenlage angeordnet sein, die eine Aussparung aufweist, die zusammen mit der ersten und der zweiten Lage die Kavität ausbildet. Die erste Lage und die zweite Lage können aus demselben oder aus unterschiedlichem Material gefertigt sein.

Die erste Lage kann beispielsweise eine Leiterplatte sein. Die zweite Lage kann eine Vergussmasse sein. Die Vergussmasse kann das Sensorelement umschließen. Die Vergussmasse kann einen Teil des Gehäuses des Sensors ausbilden. Die Vergussmasse kann das Sensorelement vor Umwelteinflüssen abschirmen. Die Vergussmasse kann elektrisch isolierend sein.

Die erste Lage kann eine durchgängige Grundfläche des Sensors bilden. Insbesondere kann die erste Lage keine schlitzförmigen Durchgangsöffnungen aufweisen, die zumindest einen Teilbereich der ersten Lage als ein Federelement oder Dämpfungselement freistellen. Gemäß einer Ausführungsform kann die Grundfläche abgesehen von Durchkontaktierungen oder Bohrungen zur Aufnahme von Steckkontakten durchgängig sein. Beispielsweise kann die erste Lage als eine durchgängige Leiterplatte ausgeführt sein. Dadurch kann ein Teil der ersten Lage eine in sich starre Grundfläche des Sensors bilden. Dadurch kann eine große Stabilität des Sensors erreicht werden. Zumindest ein weiterer Teil der ersten Lage sollte flexibel sein, um die mechanischen Spannungen aufzunehmen.

Beispielsweise kann die Trägerstruktur zwischen der ersten Lage und der zweiten Lage eine weitere Kavität zum Ausbilden eines weiteren flexiblen Teilbereichs der Trägerstruktur aufweisen. Dabei kann die erste Lage eine im Bereich der Kavitäten und in einem zwischen den Kavitäten liegenden Zentralbereich der Trägerstruktur durchgängige Grundfläche des Sensors bilden. Der Zentralbereich kann sich zwischen den Kavitäten erstrecken und das elektronische Sensorelement kann innerhalb des Zentralbereichs angeordnet sein.

Die Trägerstruktur weist eine sich in die zumindest eine Raumrichtung erstreckende elektrisch leitend ausgekleidete Durchkontaktierung auf. Die Durchkontaktierung kann eine erste Seite der Trägerstruktur, auf der das Sensorelement angeordnet sein kann, mit einer zweiten Seite der Trägerstruktur, auf der die Kontaktfläche angeordnet ist, elektrisch verbinden. Die Durchkontaktierung kann an der zweiten Seite durch eine flexible Membran quer zu der zumindest einen Raumrichtung verschlossen sein. Die flexible Membran ist als der flexible Teilbereich ausgebildet. Ein Innenraum der Durchkontaktierung ist als die Kavität ausgebildet. Die Kontaktfläche ist an der Membran angeordnet. Die Membran kann metallisch sein. Die Kontaktfläche kann in der Mitte der Membran angeordnet sein.

Der flexible Teilbereich kann umlaufend um einen Zentralbereich der Trägerstruktur ausgebildet sein. Es kann eine Mehrzahl von Kontaktflächen in dem flexiblen Teilbereich umlaufend um den Zentralbereich angeordnet sein. Die Kavität kann ebenso umlaufend um den Zentralbereich ausgebildet sein. Die Kavität kann ein umlaufender Schlitz sein. Das Sensorelement kann in dem Zentralbereich angeordnet sein.

Das Sensorelement kann ein Mikrosystem umfassen. Ein Mikrosystem kann ein mikroelektromechanisches System sein. Das Mikrosystem kann auch ein mikroelektrooptisches System sein. Durch den flexiblen Teilbereich kann das Mikrosystem spannungsfrei betrieben werden. Dadurch kann eine Kalibrierung nach dem Löten entfallen.

Ein Verfahren zum Herstellen einer Lötverbindung zwischen einem Sensor und einer Leiterplatte weist die folgenden Schritte auf:
Bereitstellen der Leiterplatte und des Sensors, wobei die Leiterplatte zumindest eine Lötstelle zum Herstellen der Lötverbindung aufweist, wobei der Sensor eine Trägerstruktur mit einem integrierten elektronischen Sensorelement aufweist, wobei die Trägerstruktur eine Kavität zum Ausbilden eines flexiblen Teilbereichs aufweist, wobei der flexible Teilbereich zumindest eine Kontaktfläche zum Herstellen der Lötverbindung aufweist und ausgebildet ist, um die Kontaktfläche zumindest in einer Raumrichtung mechanisch von dem Sensorelement zu entkoppeln, und wobei in der Kavität ein entfernbares Opfermaterial angeordnet ist, das dazu ausgebildet ist, den flexiblen Teilbereich während des Herstellens der Lötverbindung in der zumindest einen Raumrichtung zu fixieren;
Zusammenführen der Kontaktfläche des Sensors mit der Lötstelle der Leiterplatte;
Herstellen der Lötverbindung durch Aufschmelzen und Erstarren eines Lots zwischen der Kontaktfläche und der Lötstelle, wobei die Kontaktfläche elektrisch und mechanisch mit der Lötstelle verbunden wird; und
Entfernen des Opfermaterials aus der Kavität des Sensors, um das Sensorelement des Sensors von der Kontaktfläche mechanisch zu entkoppeln.

Beim Anordnen kann die Kontaktfläche in einem Toleranzbereich zu der Lötstelle angeordnet werden. Der Sensor kann eine Vielzahl von Kontaktflächen aufweisen. Die Leiterplatte kann eine dementsprechende Vielzahl von Lötstellen aufweisen. Die Kontaktstellen und Lötstellen können spiegelbildlich zueinander ausgeführt sein. Beim Löten kann eine Oberflächenspannung des Lots den Sensor an der Leiterplatte ausrichten. Beim Entfernen kann das Opfermaterial ausgeschmolzen, verdampft, gelöst und/oder abgetragen werden.

Das Entfernen des Opfermaterials kann auch vor dem Herstellen der Lötverbindung erfolgen, z. B. nach dem Aufbringen der Vergussmasse.

Der beschriebene Ansatz wird nachstehend anhand der beigefügten Zeichnungen beispielhaft näher erläutert. Es zeigen:
- Fig. 1: eine schematische Darstellung eines Sensors;
- Fig. 2: eine Darstellung eines Sensors;
- Fig. 3: eine Darstellung eines Sensors mit einer umlaufenden Kavität;
- Fig. 4: eine Darstellung eines Sensors mit einer mit einem Opfermaterial gefüllten Kavität;
- Fig. 5: eine Darstellung eines Details eines Sensors mit einer Durchkontaktierung;
- Fig. 6: eine Darstellung eines Details eines Sensors mit einer Kavität in einer Trägerstruktur;
- Fig. 7: eine Darstellung eines Details eines Sensors mit einer mehrlagigen Trägerstruktur;
- Fig. 8: eine Darstellung eines Details eines Sensors mit Opfermaterial zwischen zwei Lagen;
- Fig. 9: eine Darstellung eines Details eines Sensors mit Opfermaterial unter einer Lage;
- Fig. 10: eine Darstellung eines Details eines Sensors mit Opfermaterial an einem Rand einer Trägerstruktur;
- Fig. 11: eine Darstellung eines Details eines Sensors mit einer Kontaktfläche unter einer Durchkontaktierung gemäß einem Ausführungsbeispiel;
- Fig. 12: eine Darstellung eines Details eines Sensors mit einer dämpfermaterialgefüllten Durchkontaktierung gemäß einem Ausführungsbeispiel;
- Fig. 13: eine Schnittdarstellung durch einen Sensor mit umlaufender Kavität;
- Fig. 14: eine Darstellung eines in mehreren Raumrichtungen entkoppelten Sensors;
- Fig. 15: eine Schnittdarstellung durch einen eines in mehreren Raumrichtungen entkoppelten Sensor; und
- Fig. 16: ein Ablaufdiagramm eines Verfahrens zum Herstellen einer Lötverbindung zwischen einem Sensor und einer Leiterplatte gemäß einem Ausführungsbeispiel.

In der nachfolgenden Beschreibung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

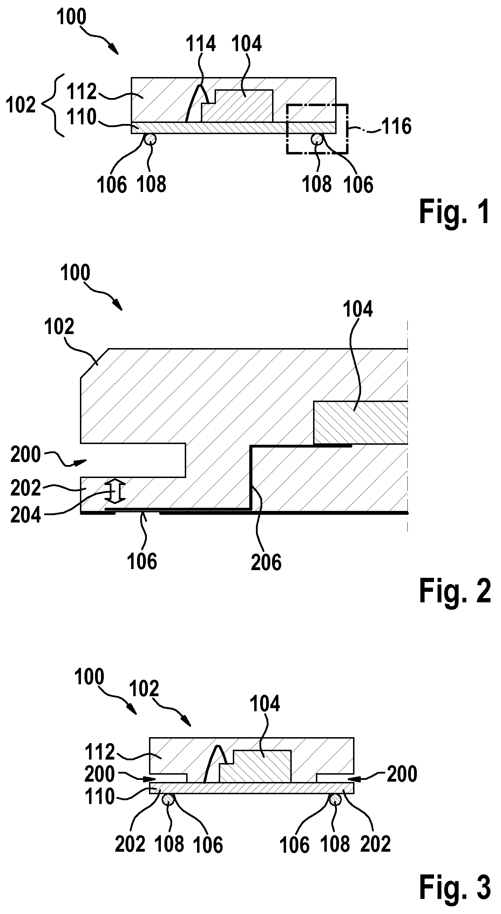

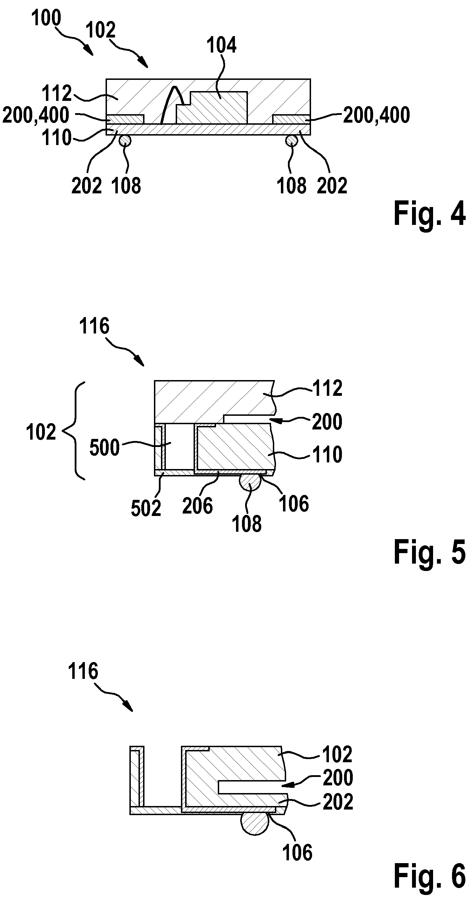

Fig. 1 zeigt eine schematische Darstellung eines Sensors 100 mit einem BGA (ball grid array) zum Kontaktieren des Sensors 100. Der Sensor 100 weist eine Trägerstruktur 102, ein Sensorelement 104 und zumindest zwei Kontaktflächen 106 auf, die mit Lotperlen 108 bzw. Lot-Balls versehen sind. Die Lotperlen 108 sind in Form eines regelmäßigen Musters angeordnet. Die Trägerstruktur 102 besteht in diesem Ausführungsbeispiel aus einer Leiterplatte 110 und einer Vergussmasse 112. Die Trägerstruktur 102 weist einen lang gestreckt rechteckigen Querschnitt auf. Die Kontaktflächen 106 sind an einer Unterseite der Leiterplatte 110 angeordnet und über Leiterbahnen in der Leiterplatte 110 elektrisch kontaktiert. Die Vergussmasse 112 ist auf einer Oberseite der Leiterplatte 110 angeordnet. Das Sensorelement 104 ist auf der Leiterplatte 110 angeordnet und über zumindest einen Bonddraht 114 elektrisch mit den Leiterbahnen der Leiterplatte 110 verbunden. Das Sensorelement 104 und der Bonddraht 114 sind von der Vergussmasse 112 umschlossen. Ein Detailbereich 116 wird in den Figuren 5 bis 12 in mit verschiedenen Ausführungsbeispielen des hier vorgestellten Ansatzes dargestellt.

In Fig. 1 ist eine schematische Darstellung (Querschnitt) eines MEMS-Sensors 100 in einem Moldgehäuse 102 gezeigt. Das MEMS-Sensorelement 104 ist in einem Moldverbund 112 angeordnet. Sensorkenndaten des Sensors 100 können sich durch mechanische Verspannung des MEMS-Elements 104 ändern. Diese Verspannung kann z. B. aus thermomechanischem Stress durch das Löten des Sensors 100 auf einer Leiterplatte bzw. Platine (Lötstress) oder aus mechanischer Belastung resultieren und über die Sensorverpackung 102, typischerweise ein Moldgehäuse 112, auf das MEMS-Element 104 übertragen werden. Dies hat eine Drift bzw. Offset der Sensorsignale zur Folge. Um eine Veränderung der Sensorperformance zwischen einem Abgleich (vor dem Löten) und nach einem Einbau auf die Kundenleiterplatte zu verhindern, können die Lötstellen 106 und das MEMS 104 mechanisch entkoppelt werden. Der hier vorgestellte Ansatz stellt eine gute und kostengünstige Lösung vor. Speziell bei LGA/BGA-Gehäusen 102 ist eine wirksame Entkopplung von Lötstellen 106 und Sensor 104 wichtig, da das Gehäuse 102 über keine Leads (Beinchen) verfügt, welche etwa bei SOIC-Gehäusen (seitlich abstehende Lötfahnen) für eine gewisse mechanische Lötstressentkopplung sorgen. Für viele Anwendungen, bei denen schwerpunktmäßig eine Lötstressentkopplung und weniger eine Vibrationsdämpfung notwendig sind, kann der hier vorgestellte Ansatz verwendet werden.

Fig. 2 zeigt eine Darstellung eines Sensors 100. Der Sensor 100 weist wie in Fig. 1 eine Trägerstruktur 102, ein integriertes elektronisches Sensorelement 104 und eine Kontaktfläche 106 auf. Zum mechanischen Entkoppeln der Kontaktfläche 106 von dem Sensorelement 104 weist der Sensor 100 in der Trägerstruktur 102 eine Kavität 200 zum Ausbilden eines flexiblen Teilbereichs 202 der Trägerstruktur 102 auf. Der flexible Teilbereich 202 ist zumindest in einer Raumrichtung 204 mechanisch von dem Sensorelement 104 entkoppelt. Der flexible Teilbereich 202 weist zumindest die eine Kontaktfläche 106 zum Herstellen einer Lötverbindung auf. Die Raumrichtung 204 ist quer zu der Kontaktfläche 106 ausgerichtet. Die Kontaktfläche 106 ist elektrisch über in die Trägerstruktur 102 integrierte Leiterbahnen 206 mit dem Sensorelement 104 verbunden.

Fig. 3 zeigt eine Darstellung eines Sensors 100 mit einer umlaufenden Kavität 200. Der Sensor 100 entspricht dem Sensor in Fig. 2. Der Sensor 100 ist hier vollständig dargestellt. Wie in Fig. 1 weist der Sensor 100 zumindest zwei Kontaktflächen 106 auf, die mit Lotperlen 108 versehen sind. Die Kontaktflächen 106 sind wie in Fig. 2 an einer Unterseite des flexiblen Teilbereichs 202 der Trägerstruktur 102 angeordnet. Die Trägerstruktur 102 weist wie in Fig. 1 eine Leiterplatte 110 und eine Vergussmasse 112 auf. Die Kavität 200 ist an einer Grenzfläche zwischen der Leiterplatte 110 und der Vergussmasse 112 angeordnet und als Aussparung aus der Vergussmasse 112 ausgeführt. Der flexible Teilbereich 202 befindet sich zwischen der umlaufenden Kavität 200 und den Kontaktflächen 106. Das Sensorelement 104 ist innerhalb der Vergussmasse 112 in einem Bereich innerhalb der umlaufenden Kavität 200 angeordnet. Das Sensorelement 104 ist auf einer den Kontaktflächen 106 abgewandten Oberfläche der Leiterplatte 110 angeordnet. Die Kavität 200 ist auf Höhe eines der Leiterplatte 110 zugewandten Abschnitt des Sensorelements 104 angeordnet. Anstelle einer umlaufenden Kavität 200 können auch mehrere einzelne Kavitäten 200 vorgesehen sein.

Mit anderen Worten zeigt Fig. 3 ein Ausführungsbeispiel für eine Lötstressentkopplung mittels Kavitäten 200 direkt oberhalb der Lötstellen 106. Durch die Kavitäten 200 werden die Lötstellen 106 vom MEMS-Element 104 in einem BGA/LGA-Gehäuse 102 mechanisch entkoppelt. Durch die Entkopplung wird ein Offset oder Drift des Sensorsignals durch den Lötprozess bzw. thermomechanischen Stress verhindert. Der hier vorgestellte Ansatz zur Lötstressentkopplung ist kostengünstig zu realisieren.

Die Lötstelle 106 wird mechanisch vom Sensorelement 104 durch eine Kavität 200 im direkten Bereich oberhalb der Lötstelle 106 entkoppelt, sodass hierdurch die Lötstelle 106 nicht mechanisch direkt mit den Sensorelementen 104 des Sensorpackages 100 in Kontakt ist. Thermomechanische Verspannungen, die über die Lötstellen 106 eingekoppelt würden, können somit kompensiert werden.

In Fig. 3 ist die Kavität 200 oberhalb der Lötstellen 106 an der Grenzfläche zwischen Leiterplatte 110 und Moldmasse 112 oberhalb der Leiterplatte 110 angeordnet.

Fig. 4 zeigt eine Darstellung eines Sensors 100 mit einer mit einem Opfermaterial 400 gefüllten Kavität 200. Der Sensor 100 entspricht dem Sensor in Fig. 3.

Zusätzlich zu Fig. 3 ist die Kavität 200 mit dem Opfermaterial 400 gefüllt. Das Opfermaterial 400 kann während der Herstellung des Sensors 100 als Platzhalter für die Kavität 200 verwendet werden. Durch das Opfermaterial 400 kann der Sensor 100 verformungsfrei gelagert werden. Das Opfermaterial 400 kann die flexiblen Teilbereiche 202 während des Lötprozesses fixieren und vor einer Verformung schützen. Das Opfermaterial 400 kann nach dem Lötprozess aus der Kavität 200 entfernt werden. Ebenso kann das Opfermaterial 400 während der Herstellung des Sensors entfernt werden, wenn die flexiblen Teilbereiche 202 standfest genug sind, um ohne Verformung gelötet zu werden. Damit kann das Entfernen des Opfermaterials 400 nach dem Löten entfallen.

Mit anderen Worten zeigt Fig. 4 eine Entkopplung von Leiterplatte 110 und Moldüberzug 112 oberhalb der Lot-Balls 108 durch eine Opferschicht 400. Um die Moldfähigkeit im Nutzen zu gewährleisten, kann der Kontakt zwischen dem Moldüberzug 112 und der Leiterplatte 110 durch eine Opferschicht 400 verhindert werden. Die Opferschicht 400 kann nach dem Moldprozess thermisch, chemisch, mechanisch oder physikalisch entfernt werden.

Die Figuren 5 bis 12 zeigen eine Vergrößerung des Detailbereichs 116 aus Fig. 1 gemäß unterschiedlicher Ausführungsbeispiele des Sensors.

Fig. 5 zeigt eine Darstellung eines Detailbereichs 116 eines Sensors mit einer Durchkontaktierung 500. Der Sensor entspricht dem Sensor in Fig. 3. Der Sensor weist die Kavität 200 an der Grenze zwischen der Leiterplatte 110 und der Moldmasse 112 auf. Zusätzlich zu Fig. 3 ist hier die Durchkontaktierung oder Via 500 dargestellt. Die Durchkontaktierung 500 verbindet die Unterseite der Leiterplatte 110 elektrisch mit der Grenzfläche zwischen der Vergussmasse 112 und der Leiterplatte 110. Die Durchkontaktierung 500 ist eine metallisch ausgekleidete Durchgangsbohrung durch die Leiterplatte 110. Die Durchkontaktierung 500 ist in diesem Ausführungsbeispiel hohl. Auf der Unterseite und der Grenzfläche der Leiterplatte 110 erstrecken sich Leiterbahnen 206. Auf der Unterseite der Leiterplatte 110 erstreckt sich die Leiterbahn 206 bis in den flexiblen Teilbereich, der durch einen an die Kavität 200 angrenzenden Abschnitt der Leiterplatte 110 in der Trägerstruktur 102 ausgebildet ist. Die Unterseite der Leiterplatte 110 ist von einem Lötstopplack 502 bedeckt, der lediglich die Kontaktfläche 106 an dem flexiblen Teilbereich freilässt. Die Kontaktfläche 106 aus Cu (Kupfer) ist vollständig von der Lotperle 108 aus Lot benetzt.

Fig. 6 zeigt eine Darstellung eines Detailbereichs 116 eines Sensors mit einer Kavität 200 in einer Trägerstruktur 102. Der dargestellte Detailbereich 116 entspricht dem in Fig. 5 gezeigten Detailbereich 116. Im Gegensatz zu Fig. 5 ist die Kavität 200 hier innerhalb einer Leiterplatte angeordnet. Die Kavität 200 ist in der Leiterplatte oberhalb der Lötstelle 106 angeordnet. Beispielsweise kann die Kavität 200 mechanisch bzw. spanabhebend in die Leiterplatte eingebracht worden sein. Damit ist der flexible Teilbereich 202 dünner und flexibler, als in Fig. 5. Die Dicke des Teilbereichs 202 ist so nicht mehr abhängig von einer Dicke der die Trägerstruktur 102 bildenden Leiterplatte.

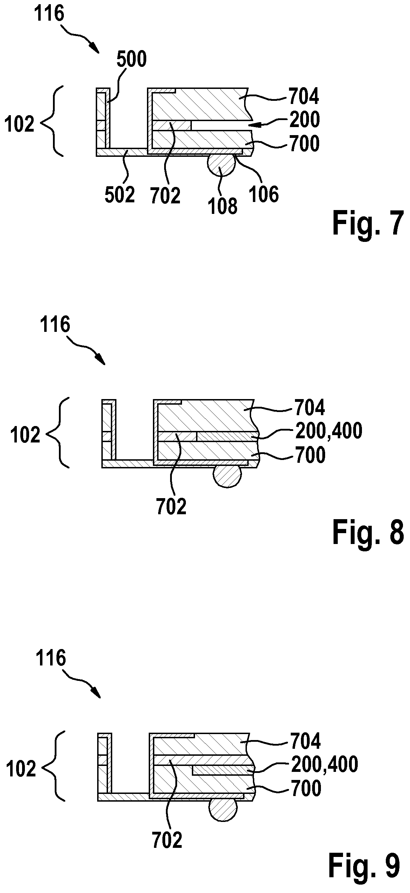

Fig. 7 zeigt eine Darstellung eines Detailbereichs 116 eines Sensors mit einer mehrlagigen Trägerstruktur 102. Der Sensor entspricht dem Sensor in Fig. 6. Im Gegensatz zu Fig. 6 ist die Trägerstruktur 102 aus mehreren Schichten, beispielsweise mehreren Leiterplattenschichten zusammengesetzt. Die Trägerstruktur 102 weist eine untere Schicht 700, eine Zwischenschicht 702 und eine obere Schicht 704 auf. Um die Kavität 200 auszubilden, steht die Zwischenlage 702 um eine Tiefe der Kavität 200 gegenüber der unteren Schicht 700 und der oberen Schicht 704 zurück. Die Kavität 200 ist entstanden, als die Schichten der Trägerstruktur 102 zusammengefügt worden sind. Die Metallisierung der Durchkontaktierung 500 aus Kupfer kann nach dem Zusammenfügen aufgebracht worden sein. Die Kontaktfläche 106 ist wie in Fig. 5 durch Lötstopplack 502 definiert. Auf der Kontaktfläche 106 ist Lot 108 angeordnet.

Der Sensor weist eine oder mehrere Kavitäten 200 in der Leiterplatte 110 oberhalb der Lötballs 108 auf. Diese Kavität oder Kavitäten 200 können beispielsweise beim Verpressen mehrerer Lagen 700, 702, 704 von Leiterplatten 110 durch das gezielte Weglassen von Bereichen einer Zwischenschicht 702, eines sogenannten Prepreg, erzeugt werden.

Fig. 8 zeigt eine Darstellung eines Detailbereichs 116 eines Sensors mit Opfermaterial 400 zwischen zwei Lagen 700, 704. Der Sensor entspricht dem Sensor in Fig. 7. Zusätzlich ist in der Kavität 200 der mehrere Schichten 700, 702, 704 umfassenden Trägerstruktur 102 das Opfermaterial 400 angeordnet. Das Opfermaterial 400 verhindert wie in Fig. 4 eine Verformung der Trägerstruktur 102 während der Herstellung und/oder während des Lötens des Sensors 100 auf eine Platine. Die Opferschicht 400 kann in den Leiterplattenprozess integriert werden und später durch physikalische, chemische, mechanische oder thermische Prozessschritte wieder entfernt werden.

Fig. 9 zeigt eine Darstellung eines Detailbereichs 116 eines Sensors mit Opfermaterial 400 unter einer Lage 702. Der Sensor entspricht dem Sensor in Fig. 8. Im Gegensatz zu Fig. 8 ist die Kavität 200 hier an einer Schichtgrenze zwischen der unteren Schicht 700 und der Zwischenschicht 702 angeordnet. Die Kavität 200 ist als Aussparung aus der unteren Schicht 700 ausgebildet. Die untere Schicht 700 weist somit einen stufenförmigen Absatz auf. Die Zwischenschicht 702 weist die gleichen Abmessungen auf, wie die untere Schicht 700 und die obere Schicht 702. Die Kavität ist wie in Fig. 8 mit dem Opfermaterial 400 gefüllt.

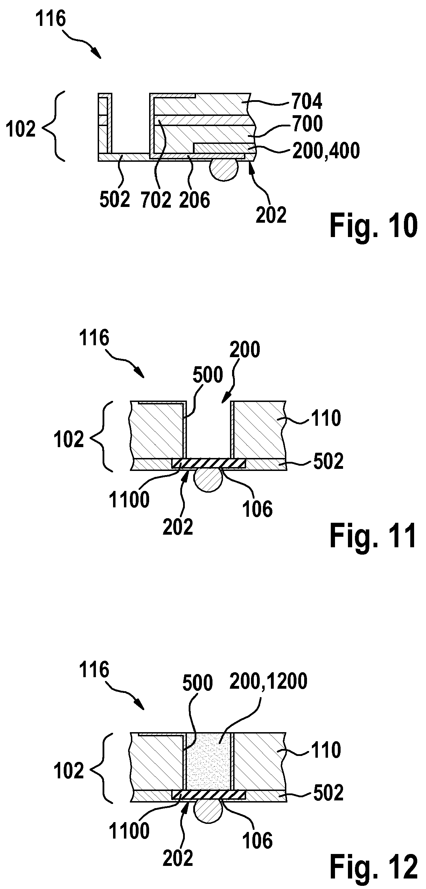

Fig. 10 zeigt eine Darstellung eines Detailbereichs 116 eines Sensors mit Opfermaterial 400 an einem Rand einer Trägerstruktur 102. Der Sensor entspricht dem Sensor in Fig. 9. Im Gegensatz zu Fig. 9 ist die Kavität 200 an einer Grenze zwischen der unteren Schicht 700 und der Leiterbahn 206 angeordnet. Wie in Fig. 9 ist die Kavität 200 als Aussparung aus der unteren Schicht 700 ausgebildet. Die Kavität 200 ist mit dem Opfermaterial 400 gefüllt. In diesem Ausführungsbeispiel kann die Kavität 200 zuerst in die untere Schicht 700 eingebracht werden, anschließend mit dem Opfermaterial gefüllt werden, und vor oder nach dem Verbinden der Lagen 700, 702, 704 zu der Tragerstruktur 102 in Form einer Leiterplatte mit den Leiterbahnen 206 und dem Lötstopplack 502 versehen werden. Durch die Kavität 200 direkt angrenzend an die Leiterbahn 206 resultiert ein besonders flexibler Teilbereich 202. Der Teilbereich 202 kann sich nach Entfernen des Opfermaterials 400 nahezu frei verformen und ermöglicht eine höchst effektive Entkopplung des Sensorelements von mechanischen Spannungen durch das Löten.

Die Verwendung einer weichen Leiterplatte 110, z. B. einer Polyimid-Leiterplatte, oder einer sehr dünnen Leiterplatte, z. B. einer FR4- bzw. BT-Leiterplatte, kann die mechanische Entkopplung weiterhin verbessern.

Mit anderen Worten zeigen die Figuren 7 bis 10 verschiedene Ausführungsformen zur mechanischen Entkopplung durch eine Kavität 200 in der Leiterplatte 110. Die Kavität 200 kann durch Weglassen des Prepregs 702 bei der Leiterplattenherstellung wie in Fig. 7 bzw. durch Einfügen einer Opferschicht 400, die nach oder während des Moldprozesses entfernt wird, erreicht werden. Verschiedene Positionen für eine Opferschicht 400 sind in den Figuren 8 bis 10 gezeigt. Die Leiterplatte 110 in Fig. 10 kann auch einlagig sein.

Fig. 11 zeigt eine Darstellung eines Detailbereichs 116 eines Sensors mit einer Kontaktfläche 106 unter einer Durchkontaktierung 500 gemäß einem Ausführungsbeispiel. Der Sensor weist die Durchkontaktierung 500 in Form eines Via im Bereich der Kontaktfläche 106 in Form eines Pad oder einer Lötstelle auf. Ein Innenraum der Durchkontaktierung 500 bildet die Kavität 200 angrenzend, hier oberhalb der Kontaktfläche 106. Nicht gepluggte Vias 500 oberhalb von Kontaktflächen 106 (Via-in-Pad) können in einer mechanischen Entkopplung resultieren. Hierzu kann die Kontaktfläche 106, welche durch den Lötstopplack 502 definiert wird, einen kleineren Durchmesser als das Via 500 aufweisen und sich vollständig im Bereich, hier unterhalb des Vias 500 befinden. Hier ist die Durchkontaktierung 500 durch eine elektrisch leitende Membran 1100 verschlossen. Die Membran 1100 ist elastisch und bildet im Bereich der Durchkontaktierung 500 den flexiblen Teilbereich 202 der Trägerstruktur 102. Die Trägerstruktur 102 kann somit eine Leiterplattenschicht 110, durch die die Durchkontaktierung 500 führt, sowie die den flexiblen Teilbereich 202 bildende Membran 1100 umfassen. Die Membran 1100 kann durch eine auf eine Oberfläche der Leiterplattenschicht 110 aufgebrachte Metallisierungsschicht gebildet sein. Das Innere der Durchkontaktierung 500 stellt die Kavität 200 dar.

Fig. 12 zeigt eine Darstellung eines Detailbereichs 116 eines Sensors mit einer dämpfermaterialgefüllten Durchkontaktierung 500 gemäß einem Ausführungsbeispiel. Der Sensor entspricht dem Sensor in Fig. 11. Zusätzlich ist in der Kavität 200 ein Dämpfermaterial 1200 angeordnet. Das Dämpfermaterial 1200 ist dazu ausgebildet, Schwingungen des flexiblen Teilbereichs 202 zu tilgen. Das Via 500 kann mit einem Dämpfergel 1200 gefüllt sein. Für diese Ausführungsformen kann es vorteilhaft sein, einen Metalldeckel anstelle eines Moldgehäuses als Schutz des Sensors zu verwenden.

Mit anderen Worten zeigen die Figuren 11 und 12 eine mechanische Entkopplung durch eine Via-in-Pad-Struktur 500. In Fig. 11 ist ein ungefülltes Via 500 dargestellt. In Fig. 12 ist ein mit einem Dämpfergel 1200 oder Gel gefülltes Via 500 dargestellt. Der Lötstopplack 502 definiert in beiden Fällen eine Lötstelle 106, deren Mittelpunkt mit dem Mittelpunkt des Vias 500 etwa übereinstimmt und deren Ausmaße kleiner sind als die des Vias 500. Thermomechanischer Stress kann kompensiert werden in dem die Kupfermetallisierung 1100 des Lötpads 106 als Federstruktur 202 fungiert.

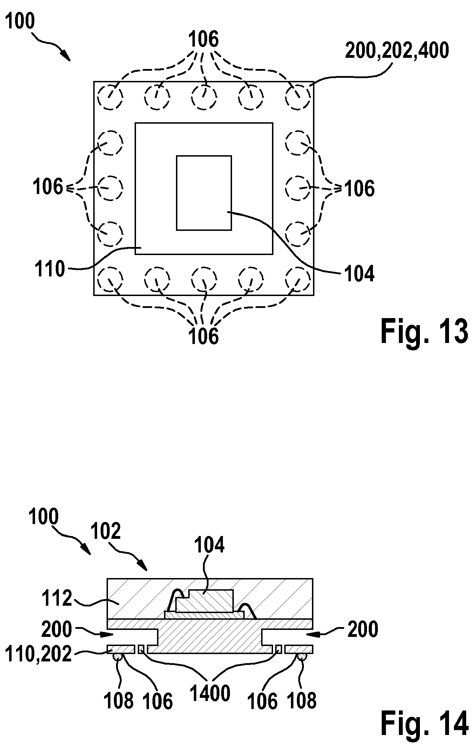

Fig. 13 zeigt eine Schnittdarstellung durch einen Sensor 100 mit umlaufender Kavität 200. Der Sensor 100 entspricht dem Sensor in Fig. 4. Eine Schnittebene verläuft durch die in der Kavität 200 angeordnete Opferschicht 400. Der Sensor 100 weist eine quadratische Grundfläche auf. Der flexible Teilbereich 202 erstreckt sich umlaufend geschlossen entlang eines Umrisses des Sensors 100. Das Sensorelement 104 weist eine rechteckige Grundfläche auf und ist mittig auf der Leiterplatte 110 angeordnet. Die Lötstellen 106 sind unterhalb des flexiblen Bereichs 202 angeordnet. 16 Lötstellen 106 sind gleichmäßig entlang des flexiblen Bereichs 202 angeordnet. Es kann sich eine gemeinsame Kavität 200 oberhalb aller Lötstellen 106 befinden. Alternativ können sich mehrere Kavitäten 200 oberhalb einzelner Lötstellen 106 oder Gruppen von Lötstellen 106 befinden.

Fig. 14 zeigt eine Darstellung eines in mehreren Raumrichtungen entkoppelten Sensors 100. Der Sensor 100 entspricht dem Sensor in Fig. 6. Zusätzlich weist der Sensor 100 im Bereich des flexiblen Teilbereichs 202 Biegefedern 1400 auf, die aus einem Material der Leiterplatte 110 herausgearbeitet sind. Die Biegefedern 1400 entkoppeln das Sensorelement 104 in allen Raumrichtungen von den Lötstellen 106. Durch die Biegefedern 1400 können auch Vibrationen gedämpft werden. Wie in Fig. 4 weist die Trägerstruktur 102 eine Leiterplatte 110 und eine darauf ausgehärtete Vergussmasse 112 auf, die das Sensorelement 104 umschließt. Die Kavität 200 ist in der Leiterplatte 110 angeordnet.

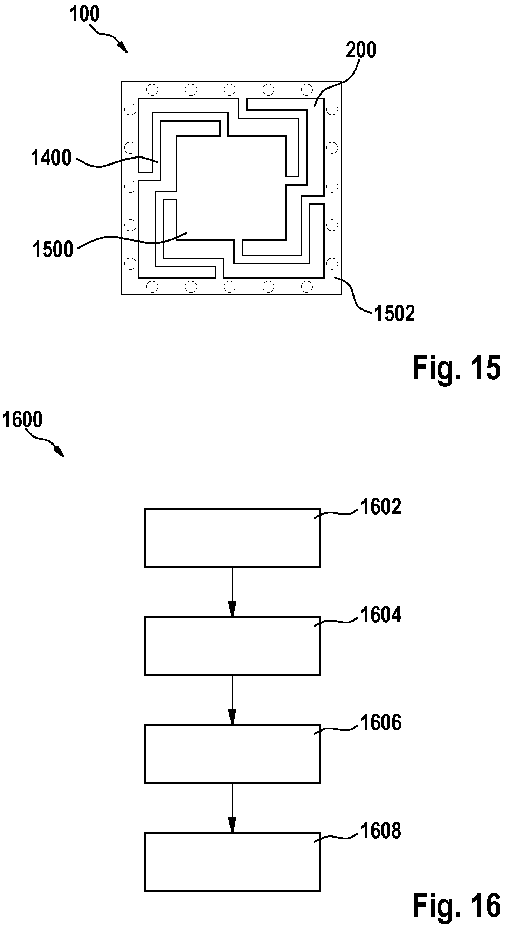

Fig. 15 zeigt eine Darstellung eines in mehreren Raumrichtungen entkoppelten Sensor 100von unten. Der Sensor 100 entspricht dem Sensor in Fig. 14. Die Biegefedern 1400 sind als Strukturen in der Leiterplatte 110 ausgeführt und wirken als Dämpferstrukturen zur Vibrationsdämpfung. Diese bestehen aus einem inneren Substratteil 1500 und einem äußeren, ringförmigen Substratteil 1502, die über balkenähnliche Strukturen 1400 verbunden sind.

Mit anderen Worten zeigen die Figuren 14 und 15 einen Sensor 100 mit Moldüberdeckung 112. Auf der Unterseite des Substrats 110 des Sensors 100 sind im Bereich der Kontaktflächen 106 Lot Balls 108 angeordnet. Aus dem Substrat 110 sind Hohlräume 200 herausgearbeitet. Ein Substrat "Ring" 1502 ist gegenüber einer Substrat "Insel" 1500 durch Balkenstrukturen 1400 bzw. Federbalken 1400 mechanisch entkoppelt.

Fig. 16 zeigt ein Ablaufdiagramm eines Verfahrens 1600 zum Herstellen einer Lötverbindung zwischen einem Sensor und einer Leiterplatte gemäß einem Ausführungsbeispiel. Das Verfahren 200 weist einen Schritt 1602 des Bereitstellens, einen Schritt 1604 des Anordnens, einen Schritt 1606 des Lötens und einen Schritt 1608 des Entfernens auf. Im Schritt 1602 des Bereitstellens werden die Leiterplatte und der Sensor bereitgestellt. Die Leiterplatte weist zumindest eine Lötstelle zum Herstellen der Lötverbindung auf. Der Sensor weist eine Trägerstruktur mit einem integrierten elektronischen Sensorelement auf. Der Sensor ist dadurch gekennzeichnet, dass die Trägerstruktur eine Kavität zum Ausbilden eines flexiblen Teilbereichs und zumindest eine Kontaktfläche zum Herstellen der Lötverbindung aufweist. Der flexible Teilbereich ist zumindest in einer Raumrichtung mechanisch von dem Sensorelement entkoppelt. Die Kontaktfläche ist elektrisch mit dem Sensorelement verbunden. In der Kavität ist ein entfernbares Opfermaterial angeordnet. Das Opfermaterial ist dazu ausgebildet, den flexiblen Teilbereich während des Herstellens der Lötverbindung in der Raumrichtung zu fixieren. Im Schritt 1604 des Anordnens wird die Kontaktfläche des Sensors über der Lötstelle der Leiterplatte angeordnet. Im Schritt 1606 des Lötens der Lötverbindung wird die Kontaktfläche durch Aufschmelzen und Erstarren eines Lots zwischen der Kontaktfläche und der Lötstelle elektrisch und mechanisch mit der Lötstelle verbunden. Im Schritt 1608 des Entfernens wird das Opfermaterial aus der Kavität des Sensors entfernt, um das Sensorelement des Sensors von dem flexiblen Teilbereich des Sensors mechanisch zu entkoppeln.

Durch die Aufnahme von Verspannungen in der Leiterplatte oder dem Cu-Pad wird der Lötstress vom Sensor entkoppelt und der Offset des Sensorsignals durch thermomechanischen Stress wird verringert. Bei Verwendung unstrukturierter einlagiger oder zweilagiger Leiterplatten kann ein kostengünstiges Basismaterial verwendet werden. Es können bereits freigegebene Standardmaterialien verwendet werden, sodass eine Produkteinführung nicht die Freigabe neuartiger Materialien voraussetzt. Der hier vorgestellte Ansatz kann bei lötstressempfindlichen MEMS-Sensoren eingesetzt werden.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden. Ferner können erfindungsgemäße Verfahrensschritte wiederholt sowie in einer anderen als in der beschriebenen Reihenfolge ausgeführt werden. Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Sensor (100) mit einer Trägerstruktur (102) mit einem integrierten elektronischen Sensorelement (104), wobei die Trägerstruktur (102) eine Kavität (200) zum Ausbilden eines flexiblen Teilbereichs (202) der Trägerstruktur (102) aufweist, wobei der flexible Teilbereich (202) zumindest eine Kontaktfläche (106) zum Herstellen einer Lötverbindung aufweist und ausgebildet ist, um die Kontaktfläche (106) zumindest in einer Raumrichtung (204) mechanisch zumindest teilweise von dem Sensorelement (104) zu entkoppeln,
**dadurch gekennzeichnet, dass**
die Trägerstruktur (102) eine sich in die zumindest eine Raumrichtung (204) erstreckende elektrisch leitend ausgekleidete Durchkontaktierung (500) aufweist, wobei die Durchkontaktierung (500) an einer Seite durch eine flexible Membran (1100) quer zu der zumindest einen Raumrichtung (204) verschlossen ist, wobei die flexible Membran (1100) als der flexible Teilbereich (202) ausgebildet ist, wobei ein Innenraum der Durchkontaktierung (500) als die Kavität (200) ausgebildet ist und die Kontaktfläche (106) an der Membran (1100) angeordnet ist.

2. Sensor (100) gemäß Anspruch 1, bei dem in der Kavität (200) ein Dämpfermaterial (1200) angeordnet ist, das dazu ausgebildet ist, Schwingungen des flexiblen Teilbereichs (202) in der zumindest einen Raumrichtung (204) zu tilgen.

3. Sensor (100) gemäß einem der vorangegangenen Ansprüche, bei dem die Trägerstruktur (102) eine erste Lage (110; 700) und zumindest eine zweite Lage (112; 702, 704) umfasst, wobei die Kavität (200) zwischen der ersten Lage (110; 700) und der zweiten Lage (112; 702, 704) angeordnet ist.

4. Sensor (100) gemäß Anspruch 3, bei dem die erste Lage (220; 700) eine Leiterplatte und die zweite Lage (112) eine Vergussmasse ist.

5. Sensor (100) gemäß Anspruch 3 oder 4, bei dem die erste Lage (220; 700) eine durchgängige Grundfläche des Sensors bildet.

6. Sensor (100) gemäß einem der vorangegangenen Ansprüche, bei dem die Durchkontaktierung (500) eine erste Seite der Trägerstruktur (102), auf der das Sensorelement (104) angeordnet ist, mit einer zweiten Seite der Trägerstruktur (102), auf der die Kontaktfläche (106) angeordnet ist, elektrisch verbindet, wobei die Durchkontaktierung (500) an der zweiten Seite durch die flexible Membran (1100) quer zu der zumindest einen Raumrichtung (204) verschlossen ist.

7. Verfahren (1600) zum Herstellen einer Lötverbindung zwischen einem Sensor (100) und einer Leiterplatte, wobei das Verfahren die folgenden Schritte aufweist:
Bereitstellen (1602) der Leiterplatte und des Sensors (100), wobei die Leiterplatte zumindest eine Lötstelle zum Herstellen der Lötverbindung aufweist, wobei der Sensor (100) eine Trägerstruktur (102) mit einem integrierten elektronischen Sensorelement (104) aufweist, wobei die Trägerstruktur (102) eine Kavität (200) zum Ausbilden eines flexiblen Teilbereichs (202) aufweist, wobei der flexible Teilbereich (202) zumindest eine Kontaktfläche (106) zum Herstellen der Lötverbindung aufweist und ausgebildet ist, um die Kontaktfläche (106) zumindest in einer Raumrichtung (204) mechanisch von dem Sensorelement (104) zu entkoppeln, wobei die Trägerstruktur (102) eine sich in die zumindest eine Raumrichtung (204) erstreckende elektrisch leitend ausgekleidete Durchkontaktierung (500) aufweist, wobei die Durchkontaktierung (500) an einer Seite durch eine flexible Membran (1100) quer zu der zumindest einen Raumrichtung (204) verschlossen ist, wobei die flexible Membran (1100) als der flexible Teilbereich (202) ausgebildet ist, wobei ein Innenraum der Durchkontaktierung (500) als die Kavität (200) ausgebildet ist und die Kontaktfläche (106) an der Membran (1100) angeordnet ist, und wobei in der Kavität (200) ein entfernbares Opfermaterial (400) angeordnet ist, das dazu ausgebildet ist, den flexiblen Teilbereich (202) in der zumindest einen Raumrichtung (204) zu fixieren;
Zusammenführen (1604) der Kontaktfläche (106) des Sensors (100) mit der Lötstelle der Leiterplatte;
Herstellen (1606) der Lötverbindung durch Aufschmelzen und Erstarren eines Lots (108) zwischen der Kontaktfläche (106) und der Lötstelle, wobei die Kontaktfläche (106) elektrisch und mechanisch mit der Lötstelle verbunden wird; und
Entfernen (1608) des Opfermaterials (400) aus der Kavität (200) des Sensors (100) vor oder während des Herstellens (1606) der Lötverbindung, um das Sensorelement (104) des Sensors (100) von der Kontaktfläche (106) mechanisch zu entkoppeln.

## Claims

1. Sensor (100) having a carrier structure (102) with an integrated electronic sensor element (104), wherein the carrier structure (102) has a cavity (200) for forming a flexible subregion (202) of the carrier structure (102), wherein the flexible subregion (202) has at least one contact area (106) for establishing a solder connection and is designed to at least partially mechanically decouple the contact area (106) from the sensor element (104) at least in one spatial direction (204),
**characterized in that**
the carrier structure (102) has an electrically conductively lined plated-through hole (500) which extends in the at least one spatial direction (204), wherein the plated-through hole (500) is closed on one side by a flexible diaphragm (1100) transversely to the at least one spatial direction (204), wherein the flexible diaphragm (1100) is designed as the flexible subregion (202), wherein an interior space in the plated-through hole (500) is designed as the cavity (200) and the contact area (106) is arranged on the diaphragm (1100).

2. Sensor (100) according to Claim 1, in which a damper material (1200) is arranged in the cavity (200), the said damper material being designed to eliminate vibrations of the flexible subregion (202) in the at least one spatial direction (204).

3. Sensor (100) according to either of the preceding claims, in which the carrier structure (102) comprises a first layer (110; 700) and at least one second layer (112; 702, 704), wherein the cavity (200) is arranged between the first layer (110; 700) and the second layer (112; 702, 704).

4. Sensor (100) according to Claim 3, in which the first layer (220; 700) is a printed circuit board, and the second layer (112) is an encapsulation compound.

5. Sensor (100) according to Claim 3 or 4, in which the first layer (220; 700) forms a continuous base area of the sensor.

6. Sensor (100) according to one of the preceding claims, in which the plated-through hole (500) electrically connects a first side of the carrier structure (102), on which first side the sensor element (104) is arranged, to a second side of the carrier structure (102), on which second side the contact area (106) is arranged, wherein the plated-through hole (500) is closed on the second side by the flexible diaphragm (1100) transversely to the at least one spatial direction (204).

7. Method (1600) for establishing a solder connection between a sensor (100) and a printed circuit board, wherein the method exhibits the following steps:
providing (1602) the printed circuit board and the sensor (100), wherein the printed circuit board has at least one solder point for establishing the solder connection, wherein the sensor (100) has a carrier structure (102) with an integrated electronic sensor element (104), wherein the carrier structure (102) has a cavity (200) for forming a flexible subregion (202), wherein the flexible subregion (202) has at least one contact area (106) for establishing the solder connection and is designed to mechanically decouple the contact area (106) from the sensor element (104) at least in one spatial direction (204), wherein the carrier structure (102) has an electrically conductively lined plated-through hole (500) which extends in the at least one spatial direction (204), wherein the plated-through hole (500) is closed on one side by a flexible diaphragm (1100) transversely to the at least one spatial direction (204), wherein the flexible diaphragm (1100) is designed as the flexible subregion (202), wherein an interior space in the plated-through hole (500) is designed as the cavity (200) and the contact area (106) is arranged on the diaphragm (1100), and wherein a removable sacrificial material (400) is arranged in the cavity (200), the said sacrificial material being designed to fix the flexible subregion (202) in the at least one spatial direction (204);
combining (1604) the contact area (106) of the sensor (100) with the solder point of the printed circuit board;
establishing (1606) the solder connection by melting and solidifying a solder (108) between the contact area (106) and the solder point, wherein the contact area (106) is electrically and mechanically connected to the solder point; and
removing (1608) the sacrificial material (400) from the cavity (200) of the sensor (100) before or during the process of establishing (1606) the solder connection in order to mechanically decouple the sensor element (104) of the sensor (100) from the contact area (106).

## Revendications

1. Capteur (100) comportant une structure de support (102) ayant un élément détecteur (104) électronique intégré, dans lequel la structure de support (102) comprend une cavité (200) destinée à former une région partielle flexible (202) de la structure de support (102), dans lequel la région partielle flexible (202) comprend au moins une surface de contact (106) destinée à créer un joint brasé et est conçue pour découpler mécaniquement au moins partiellement la surface de contact (106), dans au moins une direction spatiale (204), de l'élément détecteur (104),
**caractérisé en ce que** la structure de support (102) comprend un contact traversant (500) revêtu de manière électriquement conductrice et s'étendant dans une direction spatiale (204), dans lequel le contact traversant (500) est fermé au niveau d'une face par une membrane flexible (1100) transversalement à ladite au moins une direction spatiale (204), dans lequel la membrane flexible (1100) est réalisée sous la forme de la région partielle flexible (202), dans lequel un espace intérieur du contact traversant (500) est réalisé sous la forme d'une cavité (200) et la surface de contact (106) est disposée sur la membrane (1100).

2. Capteur (100) selon la revendication 1, dans lequel un matériau d'amortissement (1200) est disposé dans la cavité (200), celui-ci étant conçu pour amortir les oscillations de la région partielle flexible (202) dans ladite au moins une direction spatiale (204).

3. Capteur (100) selon l'une quelconque des revendications précédentes, dans lequel la structure de support (102) comprend une première couche (110 ; 700) et au moins une seconde couche (112 ; 702, 704), dans lequel la cavité (200) est disposée entre la première couche (110 ; 700) et la seconde couche (112 ; 702, 704).

4. Capteur (100) selon la revendication 3, dans lequel la première couche (220 ; 700) est une carte de circuit imprimé et la seconde couche (112) est une masse de scellement.

5. Capteur (100) selon la revendication 3 ou 4, dans lequel la première couche (220 ; 700) forme une surface de base continue du capteur.

6. Capteur (100) selon l'une quelconque des revendications précédentes, dans lequel la traversée de contact (500) connecte électriquement une première face de la structure de support (102), sur laquelle est disposé l'élément détecteur (104), à une seconde face de la structure de support (102), sur laquelle est disposée la surface de contact (106), dans lequel le contact traversant (500) est fermé au niveau de la seconde face par la membrane flexible (1100) transversalement à l'au moins une direction spatiale (204).

7. Procédé (1600) pour établir un joint brasé entre un capteur (100) et une carte de de circuit imprimé, dans lequel le procédé comprend les étapes consistant à :
fournir (1602) la carte de circuit imprimé et le capteur (100), dans lequel la carte de circuit imprimé comprend au moins un point de brasage destiné à créer le joint brasé, dans lequel le capteur (100) comprend une structure de support (102) ayant un élément détecteur (104) électronique intégré, dans lequel la structure de support (102) comprend une cavité (200) destinée à former une région partielle flexible (202), dans lequel la région partielle flexible (202) comprend au moins une surface de contact (106) destinée à créer un joint brasé et est conçue pour découpler mécaniquement la surface de contact (106), dans au moins une direction spatiale (204), de l'élément détecteur (104), dans lequel la structure de support (102) comprend un contact traversant (500) revêtu de manière électriquement conductrice s'étendant dans une direction spatiale (204), dans lequel le contact traversant (500) est fermé au niveau d'une face par une membrane flexible (1100) transversalement à ladite au moins une direction spatiale (204), dans lequel la membrane flexible (1100) est réalisée sous la forme de la région partielle (202) flexible, dans lequel un espace intérieur du contact traversant (500) est réalisé sous la forme de la cavité (200) et la surface de contact (106) est disposée sur la membrane (1100), et dans lequel un matériau sacrificiel (400) pouvant être retiré est disposé dans là cavité (200), celui-ci étant conçu pour fixer la région partielle flexible (202) dans ladite au moins une direction spatiale (204) ;
fusionner (1604) la surface de contact (106) du capteur (100) avec le point de brasage de la carte de circuit imprimé ;
créer (1606) le joint brasé par fusion et solidification d'une brasure (108) entre la surface de contact (106) et le point de brasage, dans lequel la surface de contact (106) est reliée électriquement et mécaniquement au point de brasage ; et
retirer (1608) le matériau sacrificiel (400) de la cavité (200) du capteur (100) avant ou après la création (1606) du joint brasé afin de découpler mécaniquement l'élément détecteur (104) du capteur (100) de la surface de contact (106).
